Europäisches Patentamt

European Patent Office

Office européen des brevets

(11) Publication number: **0 339 286**
**A2**

## (12) EUROPEAN PATENT APPLICATION

(21) Application number: **89105666.5**

(22) Date of filing: **30.03.89**

(51) Int. Cl.⁴: **G01R 31/28**

(30) Priority: **31.03.88 US 175966**

(43) Date of publication of application:
**02.11.89 Bulletin 89/44**

(84) Designated Contracting States:
**DE FR GB NL**

(71) Applicant: **TEKTRONIX, INC.**
**Howard Vollum Park 14150 S.W. Karl Braun**
**Drive P.O. Box 500**
**Beaverton Oregon 97077(US)**

(72) Inventor: **Yjh-Chyun, Jenq**
**4083 Colts Foot Lane**
**Lake Oswego Oregon 97035(US)**

(74) Representative: **Liska, Horst, Dr. et al**
**Patentanwälte H. Weickmann, Dr. K. Fincke,**
**F.A. Weickmann, B. Huber, Dr. H. Liska, Dr. J.**
**Prechtel Möhlstrasse 22 Postfach 86 08 20**
**D-8000 München 86(DE)**

(54) **Test system for acquiring, calculating and displaying representations of data sequences.**

(57) A system for testing electronic devices includes a waveform generator, a data acquisition system, and a computer. The waveform generator continuously generates a test signal having an adjustable parameters set by the computer in response to user input. The data acquisition system acquires data representing the output of the device under test in response to the input signal and stores the last N acquired data values. The computer transfers a data sequence from the acquisition system to another memory and generates in a window on a terminal screen a waveform display representing the stored data sequence. The computer also displays menu items referencing mathematical operations that may be performed on one or more data sequences. When a user selects one of the menu items, the computer prompts the user to select one or more windows containing waveform displays. Thereafter, the computer performs the selected operation on the data sequence controlling the waveform displays in the selected windows. When the result of the operation is a new data sequence, the computer stores the new data sequence in memory and then produces in a user-selected window a new waveform display based on the new data sequence.

FIG.1

# TEST SYSTEM FOR ACQUIRING, CALCULATING AND DISPLAYING REPRESENTATIONS OF DATA SEQUENCES

## Cross-References to Related Applications

This application is a continuation-in-part of U. S. patent application Serial Number 07/081,743, filed August 5, 1987, entitled "Digitizer Effective Resolution Measurement System Using Sinewave Parameter Estimation".

## Background of the Invention

The present invention relates to an instrument that acquires sequences of digital data, performs mathematical operations on the acquired data sequences to synthesize new data sequences and then displays waveform representations of the synthesized data sequences.

Many electronic devices produce digital or analog output signals in response to periodic input signals. To test such a device one may apply a known input signal to the device, acquire the digital or analog output signal and then process the acquired signal to produce a test result characterizing the device. When a device under test produces an output data sequence, a test instrument may store the data sequence in an acquisition memory and then perform one or more calculations on the data sequence to provide the test result. When the device under test produces an analog output signal, one may first digitize the output signal to generate a data sequence representing the output signal and then perform calculations on the data sequence in order to provide a test result.

For example, aforementioned U. S. patent application Serial Number 07/081,743, entitled "Digitizer Effective Resolution Measurement System Using Sinewave Parameter Estimation", filed August 5, 1987, describes a system for measuring the effective bits of resolution of an analog-to-digital (A/D) converter within a digitizer. The system tests an A/D converter by applying a sine wave of known frequency as input to the digitizer, obtaining a resulting output data sequence produced by the A/D converter, and then performing calculations on the output data sequence obtained. The system includes a waveform generator for producing a sine wave output signal, a switch for selectively connecting the waveform generator to the digitizer input, and a computer for controlling the switch and for performing calculations on the digitizer output data sequence. The computer accesses an acquisition memory within the digitizer to obtain the data sequence generated by the A/D converter in response to the waveform generator output signal.

What would be useful would be a test system that can provide any of a wide variety of test signals to any type of device under test, that can acquire a data sequence characterizing the output signal of the device under test produced in response to the test signal, and that can perform any of a wide variety of user-selectable calculations on the acquired data sequence so as to produce various test results.

## Summary of the Invention

In accordance with one aspect of the present invention, a computer-based instrument for testing various devices comprises an arbitrary waveform generator, a data acquisition system, and a computer. The waveform generator continuously generates a periodic analog test signal that may be applied as input to a device under test. The test signal has adjustable characteristics including amplitude, frequency and shape (i.e., sine wave, square wave, etc.) set in accordance with control data supplied to the waveform generator by the computer. The acquisition system continuously receives either a digital or an analog output signal produced by the device under test in response to the test signal. When the output signal produced by the device under test is a continuous sequence of digital data, the acquisition system stores the N most recent data values of the sequence in an addressable acquisition memory. When the device under test produces an analog output signal, the acquisition system digitizes the analog signal to produce a data sequence representing the analog signal and then stores the N most recently generated data elements of the sequence in the acquisition memory. A user inputs commands to the computer by using a mouse controlled cursor to point to menu items or windows displayed on a screen and then depressing a button on the mouse. In response to user command, the computer transfers the N element data record out of the acquisition memory, stores it another memory and generates in a window on a terminal screen a waveform display representing the stored data sequence.

In accordance with another aspect of the invention, the computer displays a menu on the screen having menu items referencing various mathematical operations that may be performed on one or more data sequences. When a user selects one of the menu items, the computer opens a conversation window on the screen and prompts the user for parameters to be employed in carrying out the operation referenced by the menu item and the user types answers to the prompts. Thereafter, when the user selects one or more windows containing waveform displays, the computer performs the selected operation on the data sequence(s) controlling the selected waveform display(s). When the result of the operation is a single data value, the computer displays the value in the conversation window. When the result of the operation is a new data sequence, the computer stores the new data sequence in memory, prompts the user to select a window and then produces in the selected window a new waveform display based on the new data sequence. The user may subsequently select the new data sequence to be the subject of another menu selected operation.

Thus, the present invention acquires and displays a waveform representation of a data sequence and permits a user to select a mathematical operation to be performed on a data sequence by selecting a menu item referencing the operation and then selecting a window in which a representation of the selected sequence is displayed.

It is accordingly an object of the invention to provide a system for generating a test signal, for acquiring a digital data sequence representing the response of a device to the test signal and for performing user selected operations on the data sequence to provide test results.

The subject matter of the present invention is particularly pointed out and distinctly claimed in the concluding portion of this specification. However, both the organization and method of operation of the invention, together with further advantages and objects thereof, may best be understood by reference to the following description taken in connection with accompanying drawings wherein like reference characters refer to like elements.

Brief Description of the Drawings

FIG. 1 is a hardware block diagram of a system for acquiring, generating and display representations of data sequences in accordance with the present invention;

FIG. 2 is a hardware block diagram of the arbitrary waveform generator of FIG. 1;

FIG. 3 is a hardware block diagram of the data acquisition unit of FIG. 1;

FIG. 4 is a hardware block diagram of the digitizer of FIG. 1;

FIGS. 5-10 show example displays produced by the system of FIG. 1; and

FIGS. 11-13 are flowcharts of software for programming the processor of FIG. 1 in accordance with the present invention.

Description of the Preferred Embodiment(s)

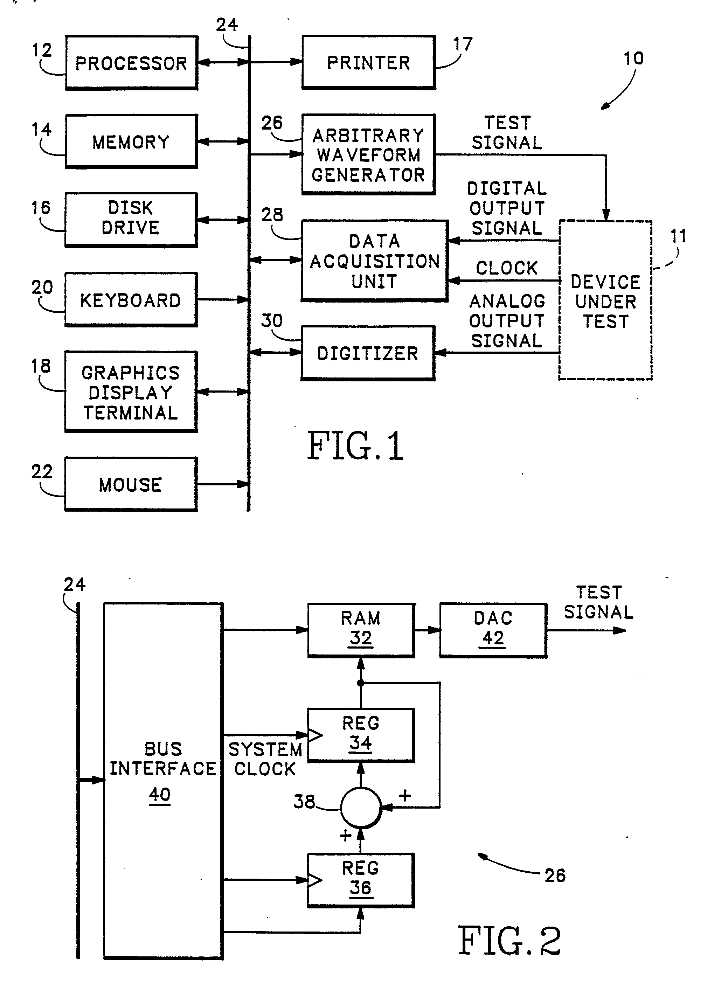

With reference to FIG. 1, there is depicted in block diagram form a system 10 for acquiring data sequences from a device under test 11, for performing mathematical operations on the acquired data sequences, and for displaying waveform representations of the results. System 10 includes a processor 12, suitably including an Intel 80386 processor and 80387 math coprocessor operating under Microsoft MSDOS version 3.2 operating system. System 10 further comprises a memory 14, a disk drive 16, a printer 17, an EGA compatible graphics display terminal or monitor 18, a keyboard 20 and a mouse 22 or other graphics input device. Devices 12, 14, 16, 17, 18, 20 and 22 are interconnected by an IBM PC/AT compatible bus 24. System 10 also includes an arbitrary waveform generator 26 for generating a periodic test signal that may be applied as input to the device under test 11. A data acquisition unit 28 monitors and stores data conveyed by a multiple bit digital output signal of the device under test 11 when produced in response to the input test signal. Data acquisition is synchronized by a CLOCK signal provided by the device under test to data acquisition unit 28. When the device under test 11 produces an analog output signal in response to the test signal, a digitizer 30 periodically digitizes the analog output signal and stores the resulting data. Devices 26, 28 and 30, also connected to bus 24, are controlled by commands from processor 12 operating under program instructions stored in memory 14.

Arbitrary waveform generator 26 provides a periodic analog test signal output having adjustable frequency, amplitude and shape (e.g., square wave, sine wave, sawtooth wave) set in accordance with control data provided by processor 12 via bus 24. A suitable arbitrary waveform generator 26 shown in FIG. 2 includes a RAM 32, two registers 34 and 36, an adder 38, a bus interface circuit 40, and a digital-to-analog converter (DAC) 42. To program waveform generator 26 to provide, for example, a sine wave output signal, processor 12 writes data stored in a file in disk drive 16 into RAM 32 via bus 24 and bus interface circuit 40. The data at each address in RAM 32 is selected such that when RAM 32 is sequentially addressed over its full address range it reads out a data sequence that varies as a single cycle of a sine wave. DAC 42 converts the data sequence to an analog sine wave signal provided as the test signal output of waveform generator 26.

RAM 32 is addressed by data stored in register 34. Register 34 stores the output of adder 38 on each cycle of a system clock signal conveyed on bus 24 and applied to an input enable terminal of register 34. Adder 38 sums the content of register 36 with the last data value stored in register 34 to provide the input to register 34. On each cycle of the system clock the address input to RAM 32 is incremented by the value of data stored in register 36. Since register 34 is of finite length, its stored value periodically overflows through zero and starts increasing again. Thus, register 34 sequentially addresses RAM 32 over its full range when register 34 is regularly input enabled by the system clock signal and causes RAM 32 to read out a periodic digital signal to DAC 42. In response, DAC 42 produces a periodic test signal of shape and amplitude controlled by the data stored in RAM 32. Processor 12 of FIG. 1 sets the data value in register 36 to control the size of of the step by which the address stored in register 34 is incremented during each system clock cycle, thereby to control the frequency of the test signal output of DAC 42.

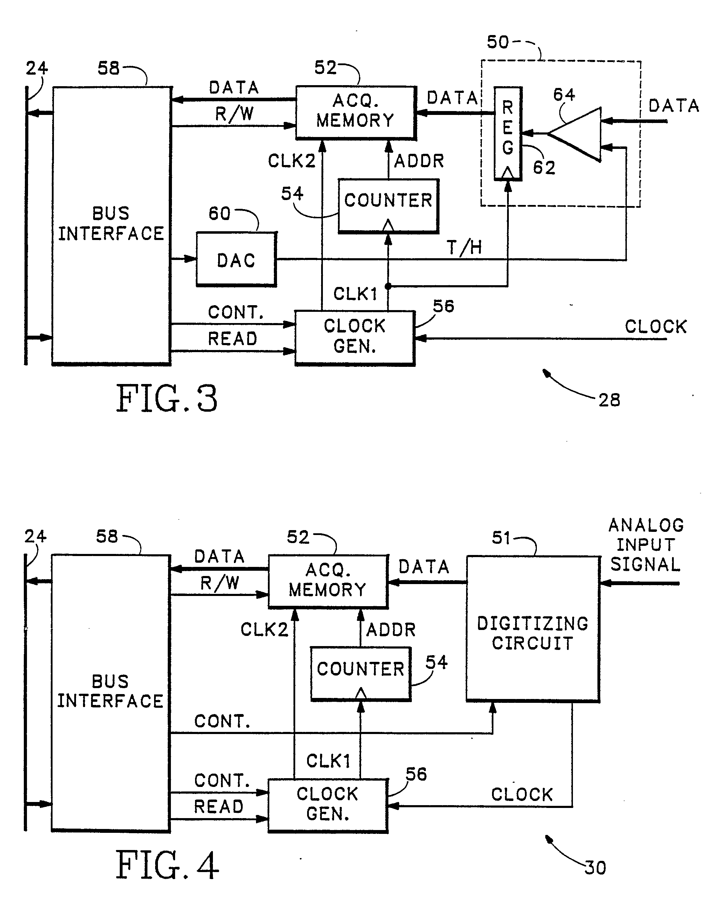

Data acquisition unit 28 of FIG. 1 is shown in more detailed block diagram form in FIG. 3. A probe interface circuit 50 receives data from the device under test and passes the data to an acquisition memory 52. A counter 54 counts pulses of an output clock signal CLK1 produced by a clock generator circuit 56 and addresses acquisition memory 52 with its count output. The device under test asserts the CLOCK signal each time it generates a new element of an output data sequence. The clock generator circuit 56 delays the CLOCK signal to provide the CLK1 signal to counter 54. Clock generator circuit 56 also provides a second clock signal CLK2 to a read/write control input of acquisition memory 52. The CLK2 signal causes the acquisition memory 52 to store the data output of probe interface circuit 50 when it is write enabled by a read/write control signal (R/W) from a bus interface circuit 58. Processor 12 of FIG. 1 controls the state of the R/W signal by transmitting commands to circuit 58 via bus 24.

To acquire and store the data output of the device under test, the R/W signal is set to cause acquisition memory 52 to store the data output of a register 62 within probe interface circuit 50. Register 62 is input enabled by the CLK1 output signal of clock generator circuit 56 and stores an output data word produced by a set of comparators 64 whenever register 62 is input enabled. Each comparator 64 receives as input a separate bit of the digital data output of the device under test. A threshold level signal (T/H) produced by a DAC 60 controls a second input of each comparator 64. The magnitude of the threshold signal is controlled by data provided by processor 12 of FIG. 1 and stored in bus interface circuit 58. The threshold signal level is set to match the logic transition level employed by the device under test so that the outputs of comparators 64 appropriately reflect the states of the input data bits. Acquisition memory 52 suitably comprises 4096 addresses and counter 54 suitably has a 12 bit output. Counter 54 counts up to 4096, overflows to 0 and then starts counting up again. Thus, once acquisition memory 52 has stored 4096 data elements of an incoming data sequence, it writes each subsequently received element of the incoming sequence over its longest stored data element.

Processor 12 of FIG. 1 can suspend the data acquisition process at any time and transfer a data sequence out of acquisition memory 52 for storage in memory 14 of FIG. 1. To read data out of acquisition memory 52, processor 12 commands bus interface circuit 58 to set the R/W signal to switch acquisition memory 52 to a read mode. At the same time, bus interface circuit 58 asserts a control signal applied to clock generator circuit 56 which causes the clock generator to produce its output CLK1 and CLK2 signals in response to a READ signal provided by bus interface circuit 58 rather than in response to the CLOCK signal provided by the device under test. Thereafter, the bus interface circuit 58 sequentially asserts the READ signal. The READ signal causes clock generator 56 to successively assert the CLK1 signal thereby causing counter 54 to sequentially address acquisition memory 52. As the data stored in acquisition memory 52 is read out it is transferred for storage in memory 14 via bus interface 58 and bus 24. When a data sequence had been read out of memory 56 processor 12 of FIG. 1 causes bus interface circuit 58 to reset the R/W and control signals to acquisition memory 52 and clock generator 56 so that the data acquisition unit 28 resumes acquiring input data from the device under test.

The digitizer 30 of FIG. 1, shown in FIG. 4, operates in a fashion substantially similar to data acquisition unit 28 of FIG. 3 except that it includes a digitizing circuit for digitizing an analog input signal to provide data input to an acquisition memory. Component devices of the digitizer 30 of FIG. 4 and the data acquisition unit 28 of FIG. 3 having similar functions are identified by similar reference numerals. The probe interface circuit 50 of the data acquisition unit 28 of FIG. 3 has been replaced in the digitizer of FIG. 4 with a conventional digitizing circuit 51 that periodically digitizes an analog input signal to produce the data input to acquisition memory 52. The digitizing circuit 51 also provides the CLOCK signal input to clock generator circuit 56. Sampling frequency, scaling and other operating parameters of digitizing circuit 51 are adjusted by control commands transmitted to the digitizing circuit from the processor 12 of FIG. 1 by way of bus 24 and bus interface circuit 58. Processor 12 can suspend data acquisition by acquisition memory 52 and read data out of the acquisition memory using the same procedure that it uses to read data out of the data acquisition unit 28 of FIG. 3 as described hereinabove.

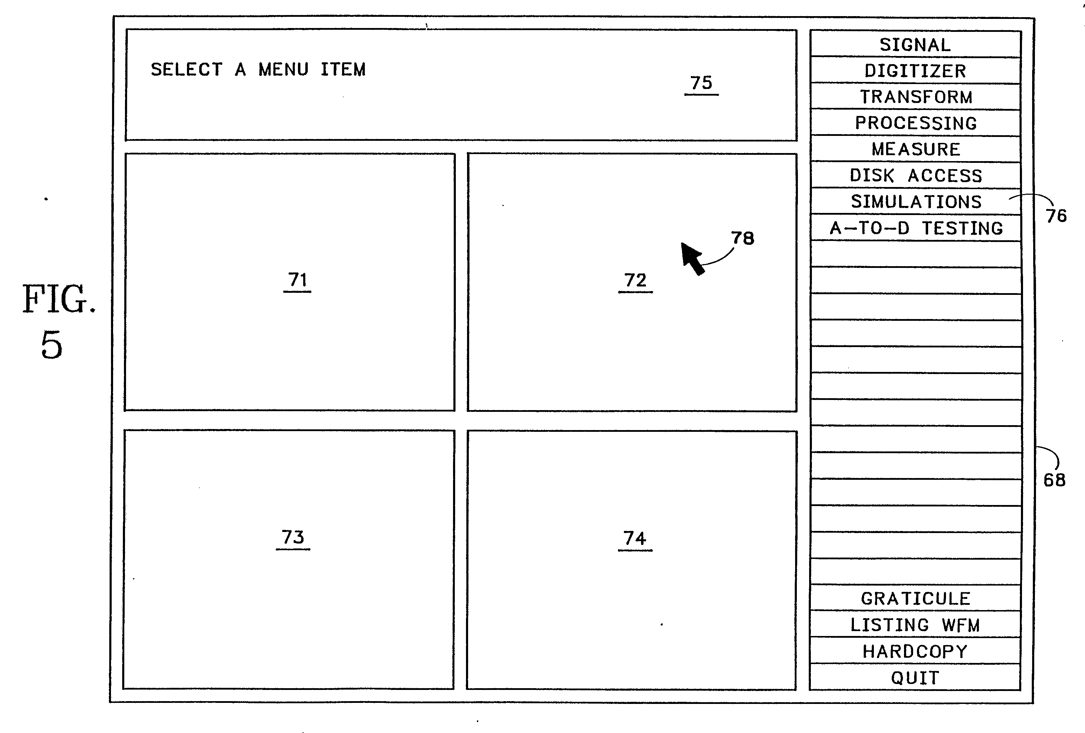

Processor 12 displays on graphics display terminal 18 of FIG. 1 waveforms representing data sequences stored in memory 14. FIG. 5 shows an initial display produced on a screen 68 of the graphics terminal at system start up. The display includes four "waveform display" windows 71-74, a "conversation" window 75, and a "menu" window 76. The system can display a waveform in each window 71-74, each waveform representing a selected data sequence stored in memory 14 of FIG. 1. The system uses conversation window 75 to display prompts to a user, to display data entered into the system via keyboard 20 of FIG. 1, and to display results of various calculations and other information. Menu window 76 may display any one of a number of menus. Each menu item references an operations to be performed or another menu to be displayed by the system when the menu item is selected. A user moves mouse 22 of FIG. 1 to position a cursor 78 at a desired location on screen 68 and may select an item of a menu in window 76 by moving the cursor over the menu item and depressing a button on the mouse.

A "main" menu is initially displayed in menu window 76. Selectable main menu items reference the following operations:

SIGNAL:

This operation replaces the main menu in window 76 with a "signal" menu that allows a user to adjust characteristics of the output test signal produced by the arbitrary waveform generator 26 of FIG. 1.

DIGITIZER:

This operation replaces the main menu with a "digitizer" menu that allows a user to adjust sampling frequency and other operating parameters of the digitizer 30 of FIG. 1.

TRANSFORM:

This operation replaces the main menu with a "transform" menu that permits a user to select various mathematical operations ("transformations") to be performed on one or more data sequences represented by waveforms displayed in user selected windows 71-74.

PROCESSING:

This operation replaces the main menu with a "processing" menu that performs selected arithmetic operations on one or more data sequences represented by waveforms displayed in user selected windows 71-74.

MEASURE:

This operation replaces the main menu with a "measurements" menu that permits a user to select various measurement operations to be performed on a displayed waveform.

DISK ACCESS:

This operation replaces the main menu with a "disk access utilities" menu that permits a user to access a directory of data files stored in disk drive 16 of FIG. 1, to load a data file containing a data sequence into memory and display a waveform representing the data sequence in a user-selected window 71-74, and to store a data sequence in the memory as a data file in disk drive 16.

SIMULATIONS:

This operation replaces the main menu with a "simulations" menu that permits a user to specify various data sequences to be generated and displayed as waveforms.

A-TO-D TESTING:

This operation replaces the main menu with an "A-to-D testing" menu that permits a user to select various test operations to be performed on an analog-to-digital converter under test.

DRAW GRATICULE:

This operation overlays a grid on a waveform display in a user selected window 71-74.

LISTING WFM:

This operation provides a printout of a data sequence controlling a selected waveform display.

HARDCOPY:

This operation provides a printout of a waveform display.

QUIT:

This operation returns system control to the disk operating system.

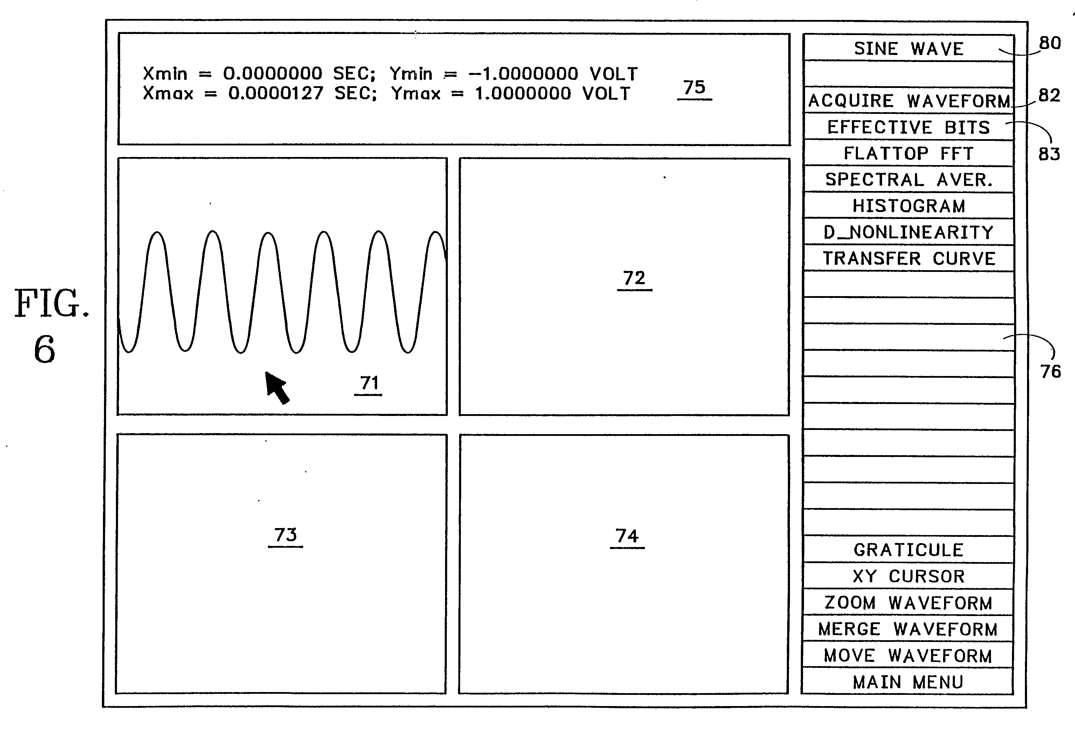

The preferred embodiment of the present invention as described herein is particularly adapted for testing an A/D converter. To test an A/D converter, a user first connects the test signal output of the arbitrary waveform generator 26 of FIG. 1 to the input of the A/D converter and connects digital and clock signal outputs of A/D converter to the data acquisition unit 28. When the user then selects the A-TO-D TESTING item of the main menu shown in FIG. 5 the system replaces the main menu display in menu window 76 with a display of the A-to-D testing menu as shown in FIG. 6. When the user selects a "sine wave" menu item 80 the system displays a prompt in conversation window 75 asking the user to enter a frequency of a sine wave test signal to be generated. When the user enters a frequency parameter value using the keyboard, the system sets arbitrary waveform generator 26 to produce a sine wave test signal output having the user-selected frequency.

The user then selects an "Acquire Waveform" menu item 82 and the system responds by displaying prompts in conversation window 75 asking the user to input the logic threshold of the A/D converter output data, the number of bits of data in the output signal, the frequency of the CLOCK signal, and a record length (not greater than 4096) to be displayed. Once the user has provided the requested input parameters, the system adjusts the threshold DAC 60 in the data acquisition unit 28 of FIG. 3 for the user-indicated threshold value and the acquisition unit begins to acquire output data produced by the A/D converter under test. The system then displays a prompt requesting the user to use the mouse to select any one of the four waveform display windows 71-74. The data acquisition unit 28 receives the data output of the A/D converter and stores the last acquired 4096 data elements of the output data sequence received from the A/D converter. After the user selects one of the windows, the system begins to periodically read a portion of the data sequence out of the acquisition memory 52 of FIG. 3, to store the data sequence as a data record in memory 14 of FIG. 1 and to generate a waveform display in the selected window 71-74 representing the stored sequence. The length of the data sequence read out of the acquisition memory is determined by the user's response to the record length prompt.

FIG. 6 shows a resulting waveform display produced in window 71. The display looks like a sine wave because the input signal to the A/D converter under test is a sine wave. When the user subsequently depresses the mouse button, the system stops reading data out of the acquisition memory and stops updating the display in window 71. The waveform display thereafter remains fixed. The system also provides a data display in the conversation window 75 indicating the maximum and minimum values Ymax and Ymin and relative times Xmin and Xmax represented by the left and right ends of the waveform display.

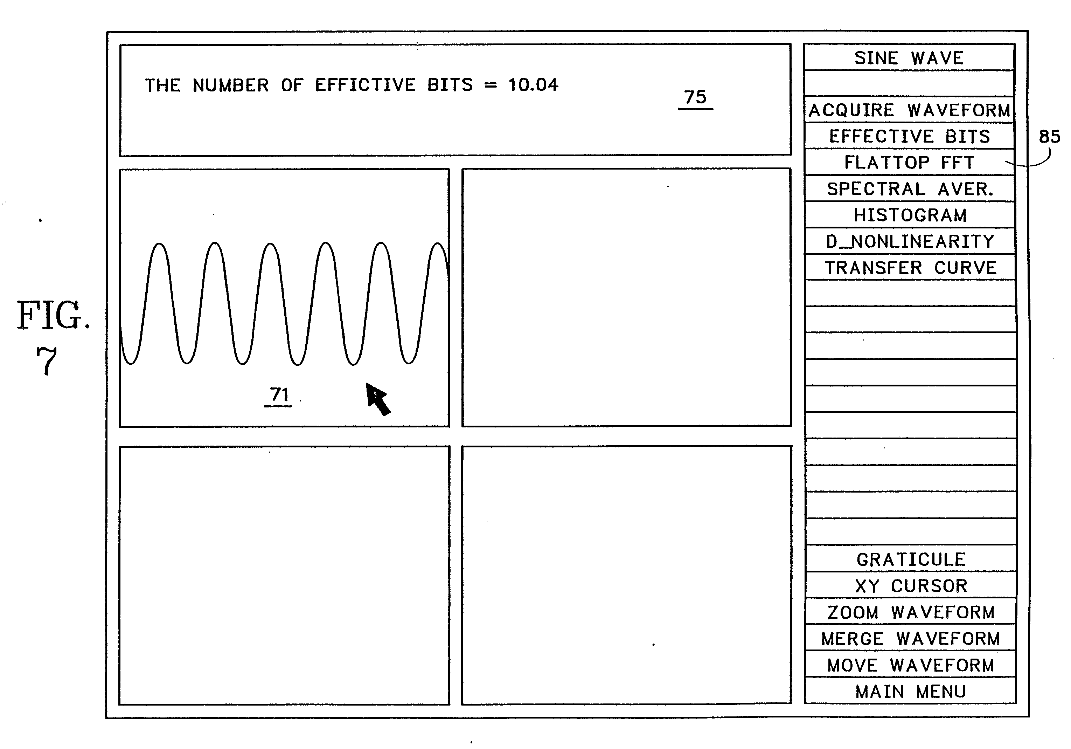

The user may then cause the system to calculate the "effective bits of resolution" of the A/D converter by selecting an "Effective Bits" menu item 83. The system responds by prompting the user to select a waveform display representing the data output of the A/D converter under test. When the user selects window 71, as shown in FIG. 7, the system calculates the effective bits of resolution of A/D converter from the data sequence stored in memory 14 that controls the waveform display in window 71. The result of the calculation is displayed in the conversation window 75. (The effective bits of resolution calculation performed is explained in detail in co-pending U. S. patent application Serial Number 07/081,743 incorporated herein by reference.)

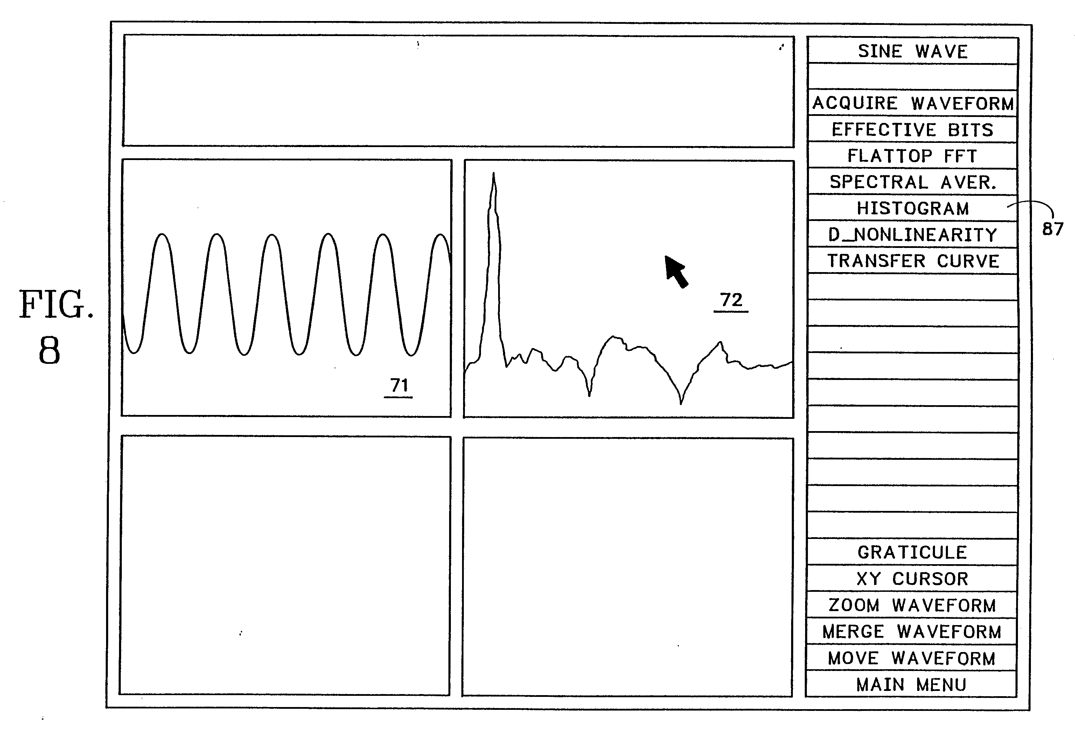

The user may next initiate a "Flattop" Fourier transform operation on the A/D converter output data. The operation generates an output data sequence representing amplitudes of frequency components of an input data sequence. An ideal A/D converter would produce an output digital sequence having only a single frequency component in response to a sine wave input signal. After the user selects the FLATTOP FFT menu item 85, the system prompts the user to select a window in which a waveform representing the input data sequence for the operation. The user then selects window 71. The system then prompts the user to select a window to contain a display of a waveform representing the Fourier transform operation output sequence to be computed. After the user selects, for example window 72, the system computes the Fourier trans form of the A/D converter output data sequence and generates the appropriate display in window 72 as shown in FIG. 8.

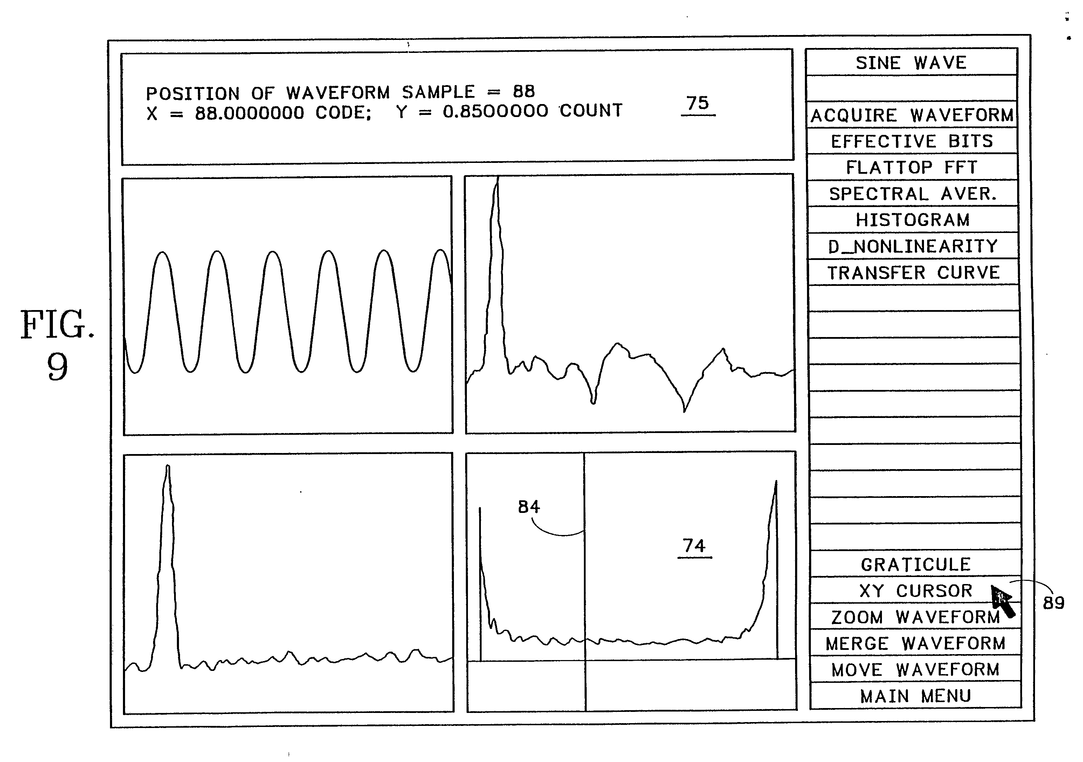

The user may select a "Histogram" menu item 87 to initiate an operation wherein the sequences of output data produced by the D/A converter under test are continuously acquired and a histogram data sequence is produced. Each element of the histogram data sequence represents a percentage of converter output data elements having a particular value. As shown in FIG. 9, the histogram is plotted in window 74 when the user selects window 74 and is continuously updated as new data is acquired. When the user subsequently depresses the mouse button, data acquisition ceases and the histogram display remains fixed.

When the user selects an XY cursor menu item 89, the system displays a horizontal and/or a vertical line cursor 84 in a selected waveform window. The operator can move the cursor using mouse 22 of FIG. 1. The system displays data in conversation window 75 indicating values represented by waveform data associated with the cursor positions. In FIG. 9 the user has initiated a vertical line cursor 84 in the window 74 containing the histogram display. The system provides a data display in the conversation window 75 indicating that the vertical line cursor 84 intersects the waveform display at a point showing that 0.85% of all values output by the A/D converter output data had a value of 88.

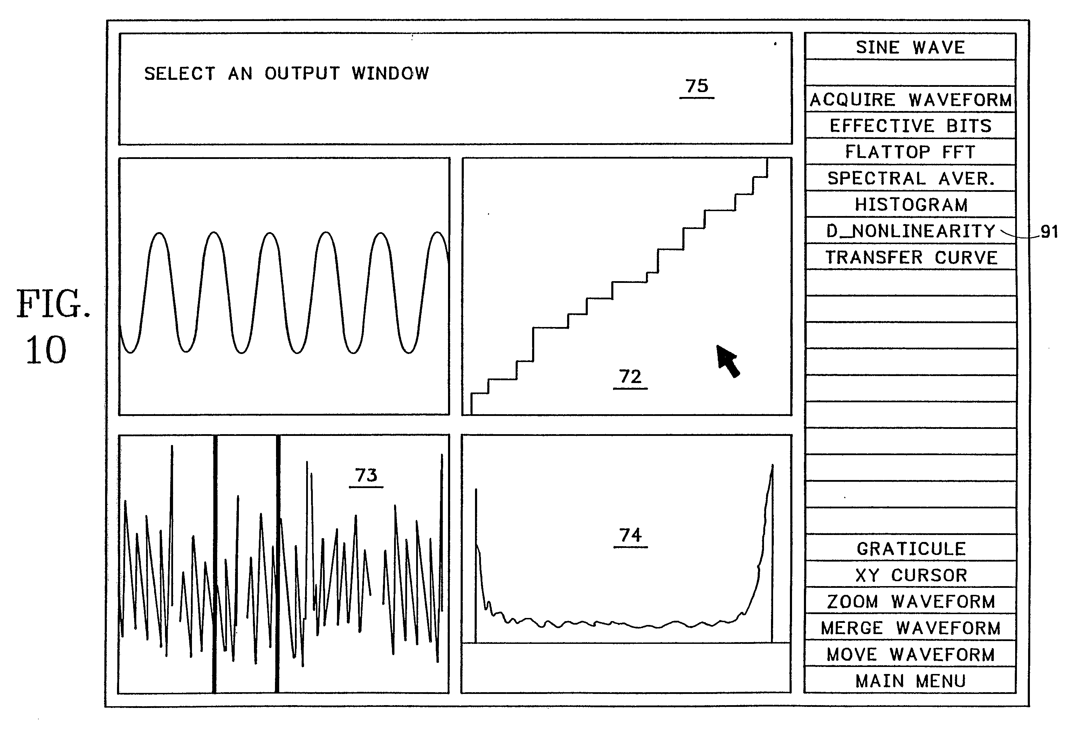

FIG. 10 shows in window 73 results of an operation performed on the histogram data represented by the display in window 74 when the "D__Nonlinearity" menu item 91 is selected. The menu item invokes a differential nonlinearity operation that processes the histogram to produce a data sequence representing the nonlinearity of the A/D converter's transfer characteristic in terms of a percentage of its least significant bit as a function of output data value. FIG. 10 also shows in window 72 the results of an operation performed on the data sequence controlling the display in window 73 when the user selects a Transfer Curve menu item. The transfer curve operation produces a data sequence indicating the transfer characteristic of the A/D converter. The transfer characteristic of an ideal A/D converter is a staircase waveform having regular steps. Any variation in step height or width is an indication of the nonlinearity of the converter.

As has been illustrated in the foregoing examples, the system of the present invention produces a test signal for application as input to a device under test, acquires an output data sequence produced by the device under test and displays a waveform representation of the data sequence. Moreover, the system permits the user to easily select and specify parameters of various mathematical operations to be performed on the acquired data sequence. When the result of an operation is a single data value, the value is displayed in the conversation window. When the result of an operation is a calculated data sequence, the system stores the calculated data sequence in memory and displays a waveform representation of the sequence in a window. The user may then select the calculated data sequence to be the subject of yet another operation by selecting the operation and then selecting the waveform representing the calculated sequence to be the subject of the operation.

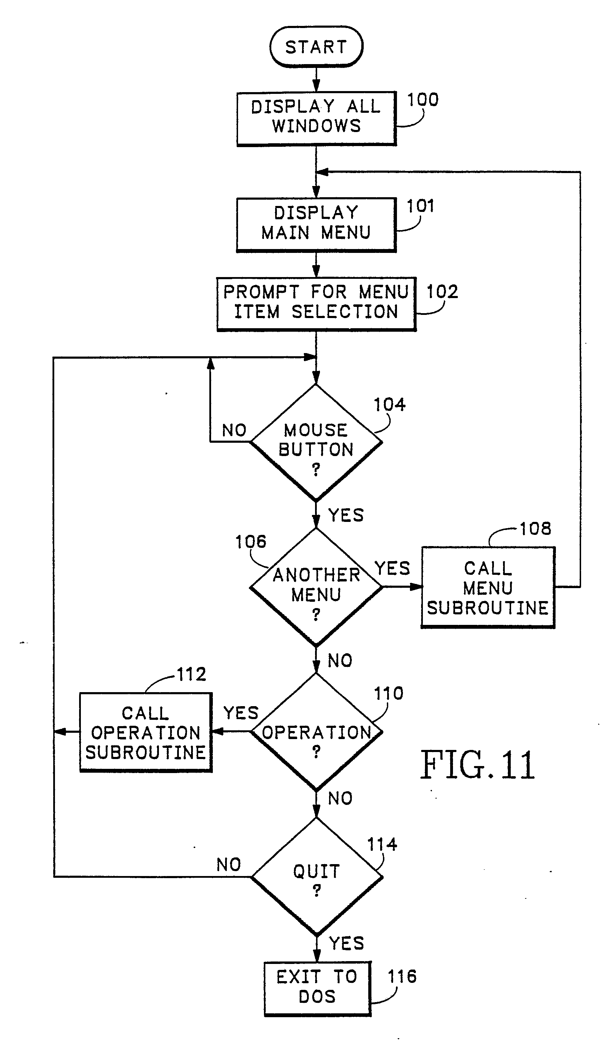

FIG. 11 shows a flow chart of a program for controlling the operation of processor 12 of FIG. 1 following system startup. Upon system startup, the system initially generates the display of the six windows 71-76 (steps 100-102) as shown in FIG. 5. Windows 71-76 are displayed in step 100 and are initially empty. But shortly thereafter, the main menu is displayed in menu window 76 (step 101) and a prompt is displayed in conversation window 75 requesting the user to select a menu item (step 102).

The system then waits for the user to depress the mouse button (step 104). When the user depresses the mouse button, the system determines from the current cursor position if the user has selected a menu item that calls another menu (step 106). If so, the system calls a subroutine that displays the other menu and responds to selections from that menu (step 108). When the called subroutine terminates, the program returns to step 101 where the main menu is again displayed. When the user selects a menu item indicating an operation other than displaying a new menu or quitting the program- (step 110), a subroutine is called that causes the system to perform the selected operation (step 112). When the operation subroutine terminates, the program returns to step 104 where the system awaits another mouse button operation. When the user selects the QUIT menu item on the main menu (step 114), the program exits to the disk operating system (step 116). When the user depresses the mouse button while the cursor is other than on a menu item, the program flows through steps 104, 106, 110 and 114 and back to step 104.

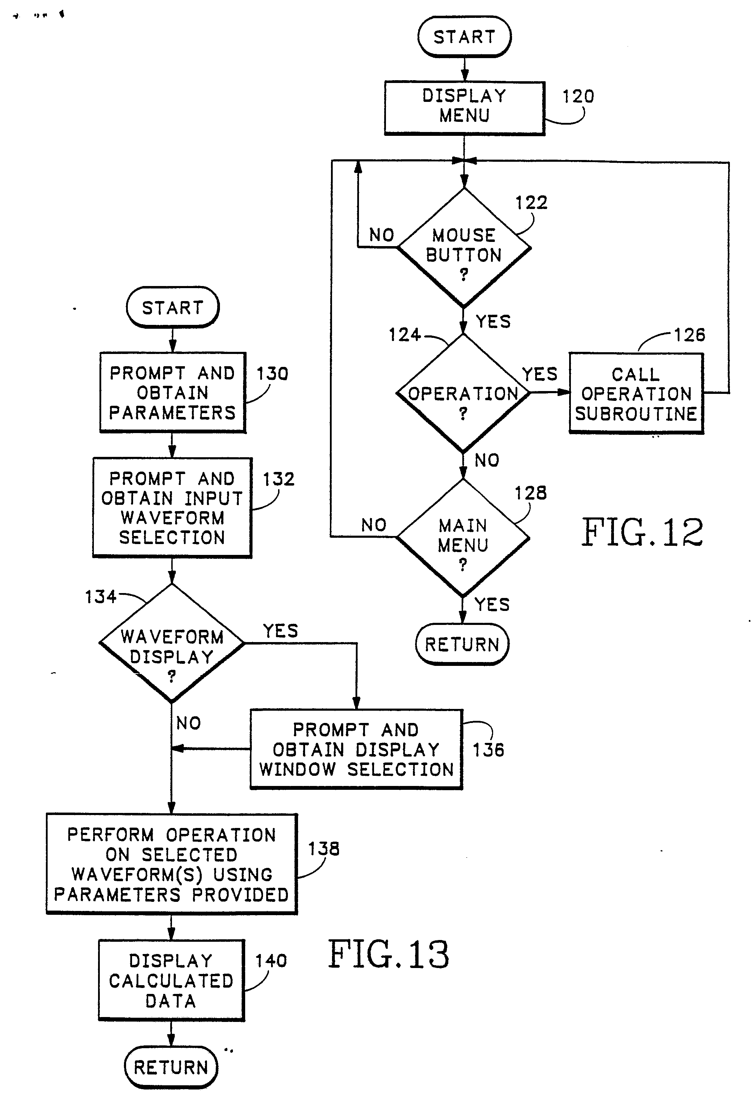

FIG. 12 is a flow chart of a typical menu subroutine that is called in step 108 of FIG. 11. Starting in step 120, the system displays an appropriate menu and then waits (step 122) until the user again depresses a mouse button. If the user selects a menu item referencing an operation (step 124), the subroutine calls yet another subroutine that performs the referenced operation (step 126). Thereafter, the program returns to step 122. When the user selects a menu item referencing the main menu (step 128), the subroutine returns to step 104 of the main menu routine of FIG. 11. When the user operates the mouse button but does not select a menu item, the subroutine of FIG. 12 cycles through steps 122, 124 and 128 and back to step 122.

FIG. 13 is a flow chart of a typical subroutine that may be called in step 126 of FIG. 12 to perform a mathematical operation on a data sequence. The system initially generates a prompt in the conversation window for input parameters (if needed) controlling the operation to be carried out by the subroutine and then obtains and stores the parameters input by the user (step 130). The system next prompts the user to select one or more windows containing waveforms and stores data indicating the memory storage locations of the data sequence(s) represented by the selected waveform(s) (step 132). If the result of the operation is to be a calculated data sequence (step 134), the system prompts the user to select a window in which to display a waveform representing the calculated data sequence (step 136). Thereafter, the system performs the operation on the selected data sequence(s) (step 138) and displays the results of the operation in the conversation window and/or in the selected waveform display window (step 140). The subroutine then returns to its caller.

Thus, the preferred embodiment of the present invention, a computer-based instrument for testing various devices, comprises an arbitrary waveform generator, a data acquisition system, and a computer. The waveform generator continuously generates an analog test signal having an adjustable parameters set by the computer in response to user input. The data acquisition system continuously acquires data representing the output of the device under test in response to the input signal and stores the last N acquired data values. In response to user input, the computer transfers a data sequence from the acquisition system to another memory and generates in a window on a terminal screen a waveform display representing the stored data sequence. The computer also displays menu items referencing mathematical operations that may be performed on one or more data sequences. When a user selects one of the menu items, the computer prompts the user to provide parameter values to be employed in carrying out the operation referenced by the menu item, and to select one or more windows containing waveform displays. Thereafter, the computer performs the selected operation on the data sequence(s) controlling the selected waveform display(s). When the result of the operation is a new data sequence, the computer stores the new data sequence in memory and produces in a user-selected window a new waveform display based on the new data sequence. The user may subsequently select the new data sequence to be the subject of another menu selected operation.

While a preferred embodiment of the present invention has been shown and described, it will be apparent to those skilled in the art that many changes and modifications may be made without departing from the invention in its broader aspects. The appended claims are therefore intended to cover all such changes and modifications as fall within the true spirit and scope of the invention.

## Claims

1. An apparatus for testing a device that continuously produces data elements of an output first data sequence in response to an input analog test signal, the apparatus comprising:
waveform generator means for generating the test signal, the test signal having a characteristic controlled by control data provided as input to the waveform generator;
data acquisition means continuously receiving the first data sequence for storing a second data sequence comprising most recently produced data elements of the first data sequence;
computer means for receiving as input parameter values from a user, for generating the control data provided as input to said waveform generator means in accordance with the parameter values, for acquiring the second data sequence from said data acquisition means, for performing a mathematical operation on the acquired second data sequence to provide a computed third data sequence and for generating a waveform display representing the third data sequence; and
bus means interconnecting said waveform generator means, said data acquisition means and said computer means for conveying the read out second data sequence from said data acquisition means to said computer means and for conveying the control data to said waveform generator means.

2. The apparatus in accordance with claim 1 wherein said test signal is periodic and said characteristic of the test signal controlled by the control data is a frequency of the test signal.

3. An apparatus for testing a device that continuously produces data elements of an output first data sequence in response to an input analog test signal, the apparatus comprising:
waveform generator means for generating the test signal, the test signal having a characteristic set in accordance with control data provided as input to the waveform generator;
data acquisition means receiving the first data sequence for storing a second data sequence comprising most recently received data elements of the first data sequence;
computer means storing instructions for performing a plurality of mathematical operations, each operation generating a calculated data sequence in response to an input data sequence, the computer means including means for receiving user input parameter values, for receiving user input selecting ones of the mathematical operations to be performed, for supplying the control data to said waveform generator means in accordance with the parameter values, and for reading the second data sequence out of said data acquisition means, performing a user selected one of the mathematical operations on the second data sequence read out to provide a computed third data sequence and providing a waveform display representing the third data sequence; and

bus means interconnecting said waveform generator means, said data acquisition means and said computer means, the bus means conveying the read out second data sequence from said data acquisition means to said computer means and conveying the control data to said waveform generator means.

4. An apparatus for testing a device that produces an output signal in response to an input test signal, the apparatus comprising:

waveform generator means for generating the test signal, the test signal having characteristics set in accordance with control data provided as input to the waveform generator;

data acquisition means responsive to the output signal for storing and reading out a data sequence representing recent magnitudes of the output signal;

computer means, including means for displaying waveforms in windows on a screen and for displaying menu items referencing mathematical operations, each producing and output data sequence in response to an input data sequence, and including means for receiving user input commands and parameter values and for acquiring user input indicating user selection of ones of the menu items and windows, the computer means generating and supplying the control data to said waveform generator means in response to the parameter values, obtaining in response to an input user command the sequence of data values read out by said data acquisition means, displaying a waveform representation of the stored data sequence in a user-selected one of the multiple windows, acquiring user input selecting one of the menu items, carrying out an operation referenced by the one menu item using the stored data sequence as an input data sequence thereby to produce a particular output data sequence, storing the particular output data sequence, and displaying a waveform representing the result of the operation in one of the windows; and

bus means interconnecting said waveform generator means, said data acquisition means and the computer means, the bus means conveying the data sequence from said data acquisition means to the computer means and conveying the control data to said waveform generator means.

5. For a computer including means for storing data sequences and instructions, means for concurrently displaying multiple windows on a screen, for displaying waveform in the windows representing the stored data sequences and for displaying menus items on the screen, and including means for obtaining menu item and window selection input from a user, a method for calculating a data sequence and displaying a representation of the calculated data sequence, the method comprising the steps of:

storing instructions for performing operations, each operation generating an output data sequence in response to an input data sequence;

storing data sequences;

displaying a plurality of windows on said screen;

displaying in separate ones of the displayed windows waveforms representing separate ones of the stored data sequences;

obtaining user input selecting a particular one of the operations;

obtaining user input selecting a first window in which a waveform is displayed;

obtaining user input selecting a second window in which to display another waveform;

performing the particular operation on a stored data sequence represented by the waveform displayed in the first window to generate an output data sequence; and

displaying a waveform representing the stored output data sequence in the second window.

6. The method of claim 5 wherein the step of obtaining user input selecting a particular one of the operations comprises the substeps of:

displaying a menu on said screen including menu items referencing ones of said operations; and

obtaining user input selecting one of said operations referenced by said menu items.

7. The method of claim 5 wherein the step of obtaining user input selecting a first window in which a waveform is displayed comprises the substeps of:

displaying a cursor on said screen at a position controlled by said user;

determining the particular position on said screen of the cursor when said user operates a push button; and

determining that a particular window has been selected as said first window when said particular position is included in said particular window.

8. For a system that stores data sequences and generates on a screen waveform displays representing stored data sequences, a method for providing a waveform display characterizing a device under test that produces an output signal in response to an input test signal, the method comprising the steps of:

storing a data sequence representing said output signal;

initiating display of windows on a screen, at least one of said windows containing a waveform display representing the stored data sequence;

displaying menu items referencing mathematical operations that may be performed on a stored data sequence to produce a new data sequence;

obtaining input indicating user selection of a menu item, user selection of a first window displayed on said screen and containing a waveform display, and user selection of a second window displayed on said screen;

performing an operation referenced by the selected menu item on a stored data sequence represented by the waveform display in the first window to produce a first calculated data sequence;

storing the first calculated data sequence;

producing in said second window a waveform display representing the first calculated data sequence;

obtaining input indicating user selection of another menu item, user selection of said second window, and user selection of a third window displayed on said screen;

performing an operation referenced by said another menu item on the first calculated data sequence represented by the waveform display in the second window to produce a second calculated data sequence;

storing the second calculated data sequence; and

producing in said third window a waveform display representing the second calculated data sequence.

9. An apparatus for testing a device that produces an output signal in response to an input analog test signal, the apparatus comprising:

waveform generator means for generating said test signal, said test signal having a characteristic controlled by control data provided as input to said waveform generator means;

data acquisition means for storing a data sequence representing at least a portion of said output signal;

waveform monitor means for displaying an output waveform in response to waveform display data;

computer means for generating the control data provided as input to said waveform generator means, for controlling said data acquisition means, for acquiring said data sequence from said data acquisition means, and for generating waveform display data representing said data sequence for said waveform monitor means; and

bus means interconnecting said waveform generator means, said data acquisition means and said computer means, for conveying said data sequence from said acquisition means to said computer means and for conveying the control data to said waveform generator means.

10. An apparatus for testing a device that produces an output first sequence of data elements in response to an input analog test signal, the apparatus comprising:

waveform generator means for generating said test signal, the test signal having a characteristic controlled by control data provided as input to the waveform generator means;

data acquisition means receiving the first sequence for storing a second sequence comprising most recently produced data elements of the first sequence;

computer means for generating the control data provided as input to said waveform generator means, for acquiring the second sequence from said data acquisition means and for generating waveform display data representing the second data sequence;

display means for displaying said waveform display data; and

bus means interconnecting said waveform generator means, said data acquisition means and said computer means, for conveying the read out second data sequence from said data acquisition means to said computer means and for conveying the control data to said waveform generator means.

FIG.1

FIG.2

FIG.3

FIG.4

FIG. 5

SELECT A MENU ITEM

75

71

72

78

73

74

SIGNAL
DIGITIZER
TRANSFORM
PROCESSING
MEASURE
DISK ACCESS
SIMULATIONS
A-TO-D TESTING

76

68

GRATICULE
LISTING WFM
HARDCOPY
QUIT

EP 0 339 286 A2

FIG. 6

Xmin = 0.0000000 SEC;  Ymin = −1.0000000 VOLT
Xmax = 0.0000127 SEC;  Ymax = 1.0000000 VOLT        _75_

_71_

_72_

_73_

_74_

| SINE WAVE | _80_ |
|---|---|
| ACQUIRE WAVEFORM | _82_ |
| EFFECTIVE BITS | _83_ |
| FLATTOP FFT | |
| SPECTRAL AVER. | |
| HISTOGRAM | |
| D_NONLINEARITY | |
| TRANSFER CURVE | |
| | _76_ |
| GRATICULE | |
| XY CURSOR | |
| ZOOM WAVEFORM | |
| MERGE WAVEFORM | |
| MOVE WAVEFORM | |
| MAIN MENU | |

EP 0 339 286 A2

FIG. 7

THE NUMBER OF EFFICTIVE BITS = 10.04    75

71

SINE WAVE

ACQUIRE WAVEFORM
EFFECTIVE BITS    85
FLATTOP FFT
SPECTRAL AVER.
HISTOGRAM
D_NONLINEARITY
TRANSFER CURVE

GRATICULE
XY CURSOR
ZOOM WAVEFORM
MERGE WAVEFORM
MOVE WAVEFORM
MAIN MENU

EP 0 339 286 A2

FIG. 8

SINE WAVE

ACQUIRE WAVEFORM
EFFECTIVE BITS
FLATTOP FFT
SPECTRAL AVER.
HISTOGRAM
D_NONLINEARITY
TRANSFER CURVE

87

71

72

GRATICULE
XY CURSOR
ZOOM WAVEFORM
MERGE WAVEFORM
MOVE WAVEFORM
MAIN MENU

EP 0 339 286 A2

FIG. 9

POSITION OF WAVEFORM SAMPLE = 88
X = 88.0000000 CODE;   Y = 0.8500000 COUNT     _75_

SINE WAVE

ACQUIRE WAVEFORM
EFFECTIVE BITS
FLATTOP FFT
SPECTRAL AVER.
HISTOGRAM
D_NONLINEARITY
TRANSFER CURVE

GRATICULE
XY CURSOR
ZOOM WAVEFORM
MERGE WAVEFORM
MOVE WAVEFORM
MAIN MENU

EP 0 339 286 A2

# FIG. 10

| | SINE WAVE |
|---|---|
| SELECT AN OUTPUT WINDOW | |
| | ACQUIRE WAVEFORM |
| _75_ | EFFECTIVE BITS |
| | FLATTOP FFT |
| | SPECTRAL AVER. |
| | HISTOGRAM |
| | D_NONLINEARITY ~91 |
| | TRANSFER CURVE |
| _72_ | |
| _73_ | |
| _74_ | GRATICULE |
| | XY CURSOR |
| | ZOOM WAVEFORM |
| | MERGE WAVEFORM |
| | MOVE WAVEFORM |
| | MAIN MENU |

EP 0 339 286 A2

FIG.11

START

DISPLAY
MENU ⌐ 120

NO ◇ MOUSE
BUTTON
? ⌐ 122

YES

124 ⌐ ◇ OPERATION
? YES → CALL
OPERATION
SUBROUTINE ⌐ 126

NO

NO ◇ MAIN
MENU
? ⌐ 128

YES

RETURN

FIG.12

START

PROMPT AND
OBTAIN
PARAMETERS ⌐ 130

PROMPT AND
OBTAIN INPUT
WAVEFORM
SELECTION ⌐ 132

134 ⌐ ◇ WAVEFORM
DISPLAY
? YES →

NO

PROMPT AND
OBTAIN DISPLAY
WINDOW SELECTION ⌐ 136

PERFORM OPERATION
ON SELECTED
WAVEFORM(S) USING
PARAMETERS PROVIDED ⌐ 138

DISPLAY
CALCULATED
DATA ⌐ 140

RETURN

FIG.13